# EUROPÄISCHE PATENTSCHRIFT

(11) **EP 3 409 645 B1**
(45) Veröffentlichungstag und Bekanntmachung des Hinweises auf die Patenterteilung: **02.10.2019**
(21) Anmeldenummer: 17173951.9
(22) Anmeldetag: 01.06.2017
(51) Int. Cl.: C01B 33/04, C01B 33/06, C01B 33/107, H01L 21/205

(54) **TRIPHENYLGERMYLSILAN UND TRICHLORSILYL-TRICHLORGERMAN FÜR DIE ERZEUGUNG VON GERMANIUM-SILIZIUM-SCHICHTEN SOWIE VERFAHREN ZU DEREN HERSTELLUNG AUS TRICHLORSILYL-TRIPHENYLGERMAN**
TRIPHENYLGERMYLSILANE AND TRICHLORSILYL-TRICHLORGERMANE FOR THE PRODUCTION OF GERMANIUM-SILICON LAYERS AS WELL AS PROCESSES FOR THEIR PREPARATION FROM TRICHLORSILYL-TRIPHENYLGERMANE
TRIPHÉNYLGERMYLSILANE ET TRICHLORSILYL-TRICHLORGERMANE POUR LA PRODUCTION DE COUCHES DE GERMANIUM-SILICIUM AINSI QUE PROCÉDÉS DE LEUR FABRICATION A PARTIR DE TRICHLORSILYL-TRIPHÉNYLGERMANE

(43) Veröffentlichungstag der Anmeldung: 05.12.2018
(73) Patentinhaber: Evonik Degussa GmbH, 45128 Essen (DE)
(72) Erfinder: TEICHMANN, Julian, 60327 Frankfurt am Main (DE); WAGNER, Matthias, 61194 Niddatal (DE); LERNER, Hans-Wolfram, 61440 Oberursel (DE)

(56) Entgegenhaltungen:
- STUEGER, H. ET AL: "Selective Synthesis and Derivatisation of Germasolicon Hydrides", INORGANIC CHEMISTRY, Bd. 55, Nr. 8, 31. März 2016 (2016-03-31), Seiten 4034-4038, XP002773640, DOI: 10.1021/acs.inorgchem.6b00349
- KAWACHI, A.; TANAKA, Y.; TAMAO, K.: "Synthesis and structures of a series of Ge-M (M = C, Si, and Sn) compounds derived from germyllithium containing three 2-(dimethylamino)phenyl groups on germanium", JOURNAL OF ORGANOMETALLIC CHEMISTRY, Bd. 590, Nr. 1, 1999, Seiten 15-24, XP002773641, ISSN: 0022-328X, DOI: 10.1016/S0022-328X(99)00386-1

## Beschreibung

Die vorliegende Erfindung betrifft die neue Verbindung Triphenylgermylsilan, ein Verfahren zur seiner Herstellung und seine Verwendung.

Halogensilane, Polyhalogensilane, Halogengermane, Polyhalogengermane, Silan, Polysilane, German, Polygermane sowie entsprechende Mischverbindungen sind lange bekannt, vgl. neben den gängigen Lehrbüchern der anorganischen Chemie auch WO 2004/036631 A2 oder C.J. Ritter et al., J. Am. Chem. Soc., 2005, 127, 9855-9864.

L. Müller et al. beschreiben in J. Organomet. Chem., 1999, 579, 156-163, u.a. die Herstellung von Trichlorsilylmethylgermane.

Aus der Angew. Chem., 1993, 105, 587-588 (G. Sih et al.) sowie aus Tetrahedron Lett., 1970, 51, 4443-4447 (F. Feher et al.) sind Methylgermylsilane sowie diverse Phenylgermylsilane bekannt, wobei die Präparation zuletzt genannter Verbindungen schwierig und aufwändig ist.

Femer sind Phenyl- und Wasserstoff-enthaltende Verbindungen bekannt, in denen Sn-Sisowie Sn-Ge-Bindungen vorliegen (J.B. Tice et al., J. Inorganic Chemistry, 2009, 48(13), 6314-6320). Dabei wird angeregt, diese Verbindungen als IR Halbleiter zu verwenden.

Singh et al. offenbaren in der Patentschrift US 7,540,920 B2 Si-Ge Verbindungen der Formel X₁X₂X₃-Si-Ge-X₄X₅X₆ mit Wasserstoff- oder Halogen-Resten X₁₋₆.

In dem Aufsatz von H. Stueger et al., "Selective Synthesis and Derivatisation of Germasilicon Hydrides", Inorganic Chemistry 2016, Bd. 55, Nr. 8, Seiten 4034 - 4038, werden Germaisotetrasilane sowie Ph₃GeSi(SiH₃)₂Li und deren Synthese vorgestellt.

Kawachi, A., et al. beschreiben Ge-M Verbindungen mit M = C, Si und Sn, hergestellt aus Germyllithium Verbindungen, bei denen drei 2-(Dimethylamino)Phenylgruppen an Ge gebunden sind, im Journal of Organometallic Chemistry, Bd. 590, Nr. 1, 1999, Seiten 15 - 24*.*

Über Triphenylgermylsilane ist bis heute nichts bekannt. So ist man seitens der Grundlagenforschung bestrebt, auch diese Verbindung aufzufinden und geeignete, möglichst einfache Herstellungswege zu finden.

Der vorliegenden Erfindung lag die Aufgabe zugrunde, Triphenylgermylsilane herzustellen und als solche bereitzustellen.

Die Aufgabe wird erfindungsgemäß entsprechend der vorliegenden Patentansprüche gelöst.

Es wurde in überraschender Weise gefunden, dass man Triphenylgermylsilane erhält, wenn man Trichlorsilyltriphenylgerman in einem Lösemittel, vorzugsweise in Diethylether, löst und unter Zusatz eines Hydrids, besonders bevorzugt mit in gleicher molarer Menge eingesetztem Lithiumaluminiumhydrid, reduziert, vorzugsweise in einer trockenen Apparatur, weiterhin bevorzugt unter Schutzgas, beispielsweise Stickstoff, und, vorzugsweise unter Durchmischung bei einer Temperatur von 5 °C bis 30 °C, besonders bevorzugt unter Raumtemperatur 20 °C, kurz RT, und über eine Dauer von 1 bis 24 Stunden, vorzugsweise während 12 h, reagieren läßt, anschließend den erhaltenen Feststoffanteil von der Lösung trennt, geeigneterweise durch Filtration oder mittels Zentrifuge, das Lösemittel geeigneterweise langsam über die Gasphase entfernt, um eine gute Kristallisation des Produktes zu erreichen, vorzugsweise unter vermindertem Druck und optional unter Minderung der Temperatur, und das bei der Reduktion entstandene Triphenylgermylsilan als kristallinen Feststoff gewinnt.

Gegenstand der vorliegenden Erfindung ist somit die neue Verbindung Triphenylgermylsilan (Ph₃Ge-SiH₃).

Gegenstand ist ebenfalls ein Verfahren zur Herstellung des erfindungsgemäßen Triphenylgermylsilan, indem man Trichlorsilyltriphenylgerman in einem Lösemittel löst und unter Zusatz eines Hydrids reduziert, wobei eine Produktlösung erhalten wird.

Die Erfindung wird im Folgenden näher erläutert.

Vorzugsweise wird in dem erfindungsgemäßen Verfahren als Lösemittel Diethylether eingesetzt, in welchem man das Trichlorsilyltriphenylgerman löst.

Weiterhin kann es vorteilhaft sein, in dem Verfahren als Hydrid bevorzugt Lithiumaluminiumhydrid oder Diisobutylaluminiumhydrid einzusetzen. Die Umsetzungsreaktion wird beschleunigt, wenn man das Hydrid unter Durchmischung einsetzt.

Des Weiteren kann man ein Verhältnis der molaren Mengen Hydrid zu Ph₃Ge-SiCl₃ in einem Bereich von 2:1 bis 1:2, vorzugsweise ein Verhältnis 1:1 auswählen.

Vorteilhaft läßt man beim erfindungsgemäßen Verfahren das Gemisch der Einsatzstoffe bei einer Temperatur von 5 °C bis 30 °C, besonders bevorzugt bei Raumtemperatur, über eine Dauer von 1 bis 24 Stunden, bevorzugt während 12 h, reagieren. Es kann vorteilhaft sein, das Gemisch während der Zeit für die Umsetzung zu rühren, weiterhin bevorzugt unter Schutzgas zu rühren, beispielsweise unter Stickstoff.

Aus der verfahrensgemäß erhaltenen Produktlösung kann man anschließend den Anteil an Feststoff abtrennen und danach das Lösemittel entfernen, vorzugsweise unter vermindertem Druck, beispielsweise in einem Bereich von 1 bis 500 hPa, und Triphenylgermylsilan als kristallines Produkt gewinnen, vorteilhaft z. B. durch Filtration oder Zentrifugieren.

Die Durchführung des erfindungsgemäßen Verfahrens ist unter Schutzgas vorteilhaft, wobei ein geeignetes Isolationsgefäß eingesetzt werden kann, beispielsweise eine Glovebox. Des Weiteren ist es vorteilhaft, das Verfahren unter Schutzgas durchzuführen, vorzugsweise unter Stickstoff oder Argon. Wasser bzw. Feuchtigkeit dürfen nicht anwesend sein.

Den beim erfindungsgemäßen Verfahren verwendeten Einsatzstoff Trichlorsilyltriphenylgerman gewinnt man geeigneterweise aus einer Umsetzung von Ph₃GeCl mit Si₂Cl₆, wie auch in der europäischen Parallelanmeldung mit dem Titel "*Neue Chlorsilylarylgermane, Verfahren zu deren Herstellung und deren Verwendung"* beschrieben.

Mit dem erfindungsgemäßen Verfahren kann auch das interessante Molekül Trichlorsilyltrichlorgerman bereitgestellt werden, welches bereits bei Singh et al. (US 7,540,920 B2) ohne eine Methode zur Herstellung offenbart ist. Hierzu wird das erfindungsgemäße Verfahren einer einfachen Modifikation unterzogen, nämlich, indem man Trichlorsilyl-triphenylgerman und AlCl₃ in einem Lösemittel, vorzugsweise in Dichlormethan löst und man, anstelle ein Hydrid zuzusetzen, eine Chlorierung des Cl₃Si-GePh₃ durchführt. Dies wird dadurch bewerkstelligt, indem man auf die soeben erhaltene Reaktionslösung, vorzugsweise auf die erhaltene Dichlormethanlösung, Chlorwasserstoff in stöchiometrischer Menge kondensiert. Auf diese Weise erhält man Zugang zu der Verbindung Cl₃Si-GeCl₃. Eine bevorzugte Ausführung dieses Verfahrens zeigt das **Beispiel B.**

Gegenstand der Erfindung ist somit auch ein Verfahren zur Herstellung von Trichlorsilyltrichlorgerman, indem man Trichlorsilyl-triphenylgerman und AlCl₃ in einem Lösemittel löst, vorzugsweise in Dichlormethan, wobei eine Reaktionslösung erhalten wird, und man anschließend Chlorwasserstoff in stöchiometrischer Menge, vorzugsweise in einer Menge von 1 bis 5 mol HCl pro mol Cl₃Si-GePh₃, besonders bevorzugt 3 mol HCl pro mol Cl₃Si-GePh₃, auf diese Reaktionslösung kondensiert. Es kann vorteilhaft sein, in diesem Verfahren AlCl₃ in einer katalytischen Menge einzusetzen, bevorzugt in einer Menge von 0,1 bis 3 mol AlCl₃ pro mol Cl₃Si-GePh₃, besonders bevorzugt von 1 bis 2 mol AlCl₃ pro mol Cl₃Si-GePh₃.

Gegenstand der Erfindung ist ebenfalls die Verwendung des erfindungsgemäßen Triphenylgermylsilan für die Erzeugung von Ge-Si Schichten oder als Überträger von SiH₃-Gruppen.

Die Funktion, SiH₃-Gruppen übertragen zu können, kennt der Stand der Technik bisher von geeigneten Zinnverbindungen.

Gleichfalls ist Gegenstand die Verwendung des erfindungsgemäß hergestellten Trichlorsilyltrichlorgerman für die Erzeugung von Si-Ge Schichten.

Die nachfolgenden Beispiele erläutern die vorliegende Erfindung zusätzlich, ohne den Gegenstand zu beschränken.

Im Rahmen der Erfindung wird unter dem Maß "equivalent", kurz "eq.", die Menge des Katalysators in mol bezogen auf die Menge Hexachlordisilan in mol verstanden. Beispielsweise bedeutet 0,1 eq. Katalysator die Menge 0,1 mol Katalysator pro mol Hexachlordisilan oder 10 mol-% Katalysator zu Hexachlordisilan.

### Analytische Methoden der Kristallstrukturbestimmung

Die Daten für alle Strukturen wurden bei 173 K mit einem STOE IPDS II Zweikreisdiffraktometer mit einer Genix Mikrofokusröhre mit Spiegeloptik unter Verwendung von Mo*K*_{α} Strahlung (*λ* = 0,71073 Å) gesammelt und mit dem frame scaling procedure des Programms *X-AREA* (Stoe & Cie, 2002) skaliert. Die Strukturen wurden mit direkten Methoden mit Hilfe des Programms *SHELXS* (Sheldrick, 2008) gelöst und gegen *F²* mit der full-matrix least-squares Technik verfeinert. Zellparameter wurden durch Verfeinerung gegen θ Werte der Reflexe mit *I*>6σ(*I*) bestimmt.

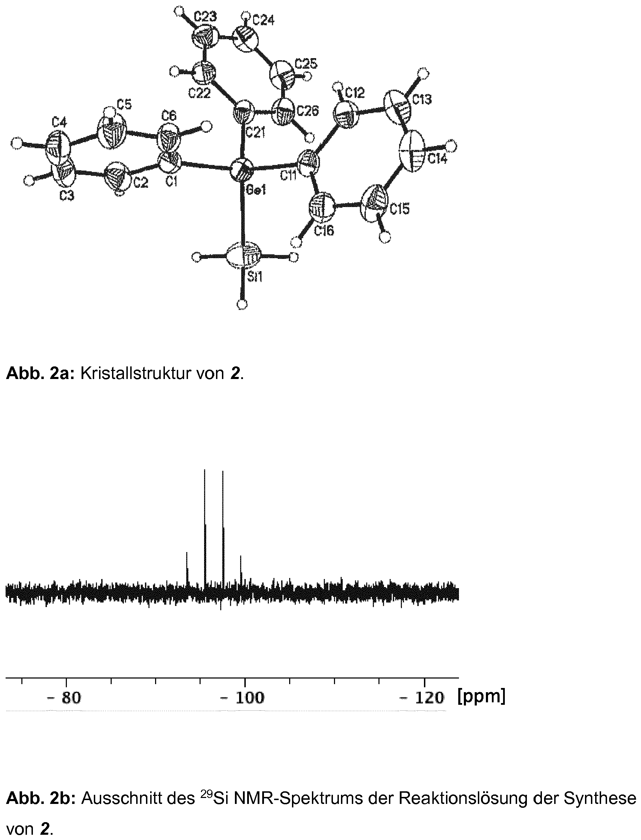

Die Röntgenstrukturanalyse des erhaltenen Einkristalles belegt die Zusammensetzung der erfindungsgemäß hergestellten Verbindung als Triphenylgermylsilan (Ph₃Ge-SiH₃), gezeigt in **Abb. 2a****.** Zusätzlich wurde eine ²⁹Si NMR-spektroskopische Untersuchung der klaren Produktlösung nach Filtration bzw. vor der Kristallisation durchgeführt, gezeigt in **Abb. 2b****.**

In den Abbildungen stehen die nicht gekennzeichneten Atome für Wasserstoff.

### Einsatzstoffe:

Ph₃GeCl, Hexachlordisilan (HCDS), Dichlormethan.

### Beispiel A: Herstellung von Silyl-triphenylgerman (2).

Zunächst erfolgte eine Synthese gemäß **Gleichung 1** aus Ph₃GeCl und Si₂Cl₆ unter Zugabe einer katalytischen Menge von 0,1 eq. [*n*Bu₄N]Cl.

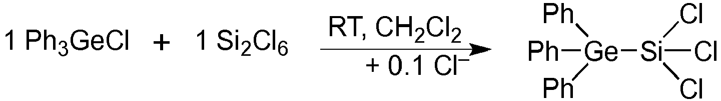

**Gleichung 1:** Umsetzung von Ph₃GeCl und Si₂Cl₆ unter Zugabe der katalytischen Menge von 0,1 eq. [*n*Bu₄N]Cl.

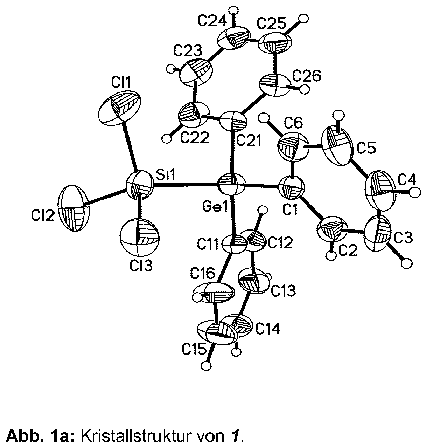

Zu einer klaren, farblosen Lösung aus 500 mg entsprechend 1,47 mmol Ph₃GeCl und 40 mg oder 0,14 mmol [*n*Bu₄N]Cl in 5 ml CH₂Cl₂ wurden unter Rühren bei Raumtemperatur 400 mg entsprechend 1,49 mmol Si₂Cl₆ gegeben. Es wurde eine klare, farblose Reaktionslösung erhalten, die bei Raumtemperatur während 12 h gerührt wurde. Aus der Reaktionslösung ließ sich nach langsamem Entfernen des Lösungsmittels ***1*** als Rohprodukt in Form eines farblosen, kristallinen Feststoffes Ph₃Ge-SiCl₃ (***1***) isolieren. Die Ausbeute betrug 59 %. Das Rohprodukt enthielt noch zu etwa 30 % das Edukt Ph₃GeCl. Durch Röntgendiffraktometrie konnte die Kristallstruktur von ***1*** ermittelt werden, gezeigt in **Abb. 1a****.**

Das ²⁹Si NMR Spektrum von ***1*** sind in Abb. 1b dargestellt.

Alle Ergebnisse einer ¹H, ¹³C und ²⁹Si NMR-spektroskopischen Untersuchung:
**²⁹Si NMR (99,4 MHz, CD₂Cl₂, 298 K):**
   δ = 13,3.
**¹H NMR (500,2 MHz, CD₂Cl₂, 298 K):**
   δ = 7,58 (m); 7,75 (dd ³J(H,H) = 8,0 Hz, ²J(H,H) = 1,4 Hz).
**¹³C NMR (125,0 MHz, CD₂Cl₂, 298 K):**
   δ = 128,9; 130,1; 132,2; 135,3.

Anschließend wurde das erhaltene Ph₃Ge-SiCl₃ (***1***) gemäß **Gleichung 2** mit LiAlH₄ in Diethylether umgesetzt.

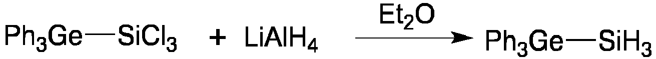

**Gleichung 2:** Umsetzung von ***1*** und LiAlH₄.

Zu einer Suspension aus 9 mg LiAlH₄, entsprechend 0,2 mmol, in Et₂O wurde bei Raumtemperatur eine klare, farblose Lösung von ***1*** in einer Menge von 100 mg oder 0,2 mmol in Et₂O gegeben. Diese Reaktionslösung wurde während 12 h bei Raumtemperatur gerührt. Aus der Reaktionslösung ließ sich nach Entfernen des restlichen LiAlH₄ durch Filtration und langsamem Entfernen des Lösungsmittels Ph₃Ge-SiH₃ (***2***) als farbloser, kristalliner Feststoff in einer Ausbeute von 76 % isolieren.

Durch Röntgendiffraktometrie konnte die Kristallstruktur von ***2*** ermittelt werden, gezeigt in **Abb. 2a****.**

Das ²⁹Si NMR Spektrum von ***2*** ist in **Abb. 2b** dargestellt, mit der Ordinate in relativen Einheiten. Alle Ergebnisse einer ¹H, ¹³C und ²⁹Si NMR-spektroskopischen Untersuchung:
**²⁹Si NMR (99,4 MHz; c Et₂O; 298 K):**
   δ = q 96,5 ¹J(¹H,²⁹Si) = 197 Hz.
**¹H NMR (500,2 MHz; undeuterierter Et₂O; 298 K):**
   δ = s 4,3 (nur 1 ²⁹Si Satellit mit 98 Hz Kopplungskonstante ist zu erkennen. Der andere liegt unter dem Et₂O Signal); m 8,1; m 8,2.
**¹³C NMR (125,0 MHz; undeuterierter Et₂O; 298 K):**
   δ = 128,9; 129,4; 135,5; 137,2.

### Beispiel B: Herstellung von Trichlorsilyltrichlorgerman (3).

Die Chlorierung von Cl₃Si-GePh₃ erfolgte gemäß **Gleichung 3.** Dabei wurde eine stöchiometrische Menge, nämlich 3 mmol HCl pro mmol Cl₃Si-GePh₃ (***2***), auf eine Dichlormethanlösung aus ***2*** und AlCl₃ kondensiert.

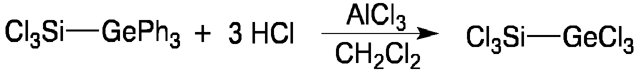

**Gleichung 3**: Chlorierung von Cl₃Si-GePh₃ mit HCl und katalytischer Menge AlCl₃.

Zu einer klaren und farblosen Lösung aus 180 mg oder 0,41 mmol von ***2*** in 5 ml CH₂Cl₂ wurde unter Rühren bei Raumtemperatur 100 mg oder 0,75 mmol AlCl₃ gegeben, woraufhin sich die Reaktionslösung intensiv rot färbte. Diese rote Reaktionslösung wurde mit flüssigem Stickstoff auf -196,15 °C gekühlt und anschließend 44,846 g entsprechend 30,75 ml oder 1,23 mmol gasförmiger Chlorwasserstoff aufkondensiert.

Nach 10 Minuten wurde die Kühlung entfernt und das Reaktionsgemisch auf Raumtemperatur erwärmt.

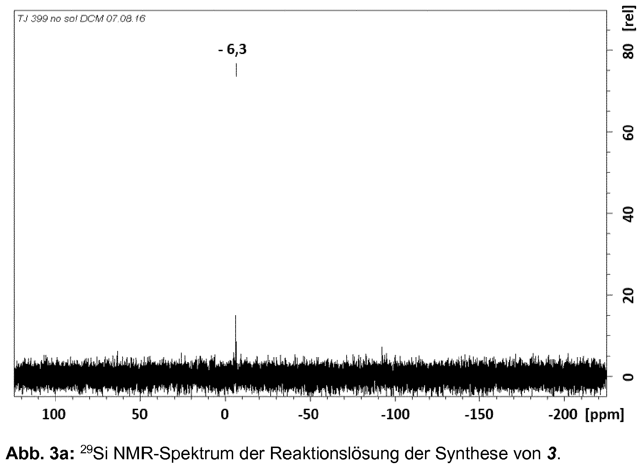

Eine ²⁹Si NMR-spektroskopische Untersuchung der Reaktionslösung zeigte das NMR Signal von ***3*** bei einer chemischen Verschiebung von -6,3 ppm, gezeigt in **Abb. 3a****.**

Alle Ergebnisse einer ²⁹Si NMR-spektroskopischen Untersuchung:
**²⁹Si NMR (99,4 MHz; CH₂Cl₂; 298 K):**
δ = - 6,3.

## Patentansprüche

1. Triphenylgermylsilan (Ph₃Ge-SiH₃).

2. Verfahren zur Herstellung von Triphenylgermylsilan nach Anspruch 1, indem man Trichlorsilyl-triphenylgerman in einem Lösemittel löst und unter Zusatz eines Hydrids reduziert, wobei eine Produktlösung erhalten wird.

3. Verfahren nach Anspruch 2, **dadurch gekennzeichnet, dass** man als Lösemittel Diethylether einsetzt.

4. Verfahren nach Anspruch 2 oder 3, **dadurch gekennzeichnet, dass** man als Hydrid Lithiumaluminiumhydrid einsetzt.

5. Verfahren nach einem der vorangehenden Ansprüche, **dadurch gekennzeichnet, dass** man das Hydrid in einem molaren Verhältnis zu Ph₃Ge-SiCl₃ im Bereich von 2:1 bis 1:2, vorzugsweise im Verhältnis 1:1, einsetzt.

6. Verfahren nach einem der vorangehenden Ansprüche, **dadurch gekennzeichnet, dass** man das Gemisch der Einsatzstoffe bei einer Temperatur von 5 °C bis 30 °C über eine Dauer von 1 bis 24 Stunden reagieren.

7. Verfahren nach einem der vorangehenden Ansprüche, **dadurch gekennzeichnet, dass** man aus der Produktlösung den Anteil an Feststoff abtrennt und danach das Lösemittel entfernt, vorzugsweise unter vermindertem Druck, und Triphenylgermylsilan als kristallines Produkt gewinnt.

8. Verfahren nach einem der vorangehenden Ansprüche, **dadurch gekennzeichnet, dass** man den Einsatzstoff Trichlorsilyltriphenylgerman aus einer Umsetzung von Ph₃GeCl mit Si₂Cl₆ gewinnt.

9. Verwendung von Triphenylgermylsilan nach Anspruch 1 für die Erzeugung von GeSi-Schichten oder als Überträger von SiH₃-Gruppen.

10. Verfahren zur Herstellung von Trichlorsilyltrichlorgerman,
indem man
Trichlorsilyl-triphenylgerman und AlCl₃ in einem Lösemittel löst, wobei eine Reaktionslösung erhalten wird, und man anschließend Chlorwasserstoff in stöchiometrischer Menge auf diese Reaktionslösung kondensiert.

11. Verfahren nach Anspruch 10, indem man
Chlorwasserstoff in stöchiometrischer Menge, vorzugsweise in einer Menge von 1 bis 5 mol HCl pro mol Cl₃Si-GePh₃, bevorzugt 3 mol HCl pro mol Cl₃Si-GePh₃ einsetzt, und/oder
AlCl₃ in einer Menge von 0,1 bis 3 mol AlCl₃ pro mol Cl₃Si-GePh₃, bevorzugt von 1 bis 2 mol AlCl₃ pro mol Cl₃Si-GePh₃ einsetzt.

12. Verwendung von Trichlorsilyltrichlorgerman, hergestellt nach Anspruch 10 oder 11, für die Erzeugung von GeSi-Schichten.

## Claims

1. Triphenylgermylsilane (Ph₃Ge-SiH₃).

2. Process for preparing triphenylgermylsilane according to Claim 1, by dissolving trichlorosilyltriphenylgermane in a solvent and reducing it with addition of a hydride to obtain a product solution.

3. Process according to Claim 2, **characterized in that** the solvent used is diethyl ether.

4. Process according to Claim 2 or 3, **characterized in that** the hydride used is lithium aluminium hydride.

5. Process according to any of the preceding claims, **characterized in that** the hydride is used in a molar ratio to Ph₃Ge-SiCl₃ in the range from 2:1 to 1:2, preferably in the ratio of 1:1.

6. Process according to any of the preceding claims, **characterized in that** the mixture of the feedstocks reacts at a temperature of 5°C to 30°C over a period of 1 to 24 hours.

7. Process according to any of the preceding claims, **characterized in that** the proportion of solids is separated from the product solution and then the solvent is removed, preferably under reduced pressure, and triphenylgermylsilane is obtained as a crystalline product.

8. Process according to any of the preceding claims, **characterized in that** the trichlorosilyltriphenylgermane feedstock is obtained from a reaction of Ph₃GeCl with Si₂Cl₆.

9. Use of triphenylgermylsilane according to Claim 1 for the production of GeSi layers or as transferrer of SiH₃ groups.

10. Process for preparing
trichlorosilyltrichlorogermane,
by
dissolving trichlorosilyltriphenylgermane and AlCl₃ in a solvent to obtain a reaction solution, and then
condensing hydrogen chloride onto this reaction solution in a stoichiometric amount.

11. Process according to Claim 10, wherein
hydrogen chloride is used in a stoichiometric amount, preferably in an amount of 1 to 5 mol HCl per mole of Cl₃Si-GePh₃, preferably 3 mol of HCl per mole of Cl₃Si-GePh₃, and/or
AlCl₃ is used pin an amount of 0.1 to 3 mol of AlCl₃ per mole of Cl₃Si-GePh₃, preferably of 1 to 2 mol of AlCl₃ per mole of Cl₃Si-GePh₃.

12. Use of trichlorosilyltrichlorogermane, prepared according to Claim 10 or 11, for the production of GeSi layers.

## Revendications

1. Triphénylgermylsilane (Ph₃Ge-SiH₃).

2. Procédé de fabrication de triphénylgermylsilane selon la revendication 1, selon lequel du trichlorosilyl-triphénylgermane est dissous dans un solvant et réduit avec ajout d'un hydrure, une solution de produits étant obtenue.

3. Procédé selon la revendication 2, **caractérisé en ce que** l'éther diéthylique est utilisé en tant que solvant.

4. Procédé selon la revendication 2 ou 3, **caractérisé en ce que** l'hydrure de lithium et d'aluminium est utilisé en tant qu'hydrure.

5. Procédé selon l'une quelconque des revendications précédentes, **caractérisé en ce que** l'hydrure est utilisé en un rapport molaire par rapport à Ph₃Ge-SiCl₃ dans la plage allant de 2:1 à 1:2, de préférence en un rapport de 1:1.

6. Procédé selon l'une quelconque des revendications précédentes, **caractérisé en ce que** le mélange des matières premières réagit à une température de 5 °C à 30 °C pendant une durée de 1 à 24 heures.

7. Procédé selon l'une quelconque des revendications précédentes, **caractérisé en ce que** la fraction de solides est séparée de la solution de produits, puis le solvant est éliminé, de préférence sous pression réduite, et le triphénylgermylsilane est obtenu sous la forme d'un produit cristallin.

8. Procédé selon l'une quelconque des revendications précédentes, **caractérisé en ce que** la matière première trichlorosilyltriphénylgermane est obtenue à partir d'une réaction de Ph₃GeCl avec Si₂Cl₆.

9. Utilisation de triphénylgermylsilane selon la revendication 1 pour la formation de couches de GeSi ou en tant que porteur de groupes SiH₃.

10. Procédé de fabrication de trichlorosilyltrichlorogermane, selon lequel
du trichlorosilyl-triphénylgermane et de l'AlCl₃ sont dissous dans un solvant, une solution de réaction étant obtenue, puis
du chlorure d'hydrogène est condensé en quantité stoechiométrique sur cette solution de réaction.

11. Procédé selon la revendication 10, selon lequel le chlorure d'hydrogène est utilisé en quantité stoechiométrique, de préférence en une quantité de 1 à 5 moles d'HCl par mole de Cl₃Si-GePh₃, de préférence de 3 moles d'HCl par mole de Cl₃Si-GePh₃, et/ou
l'AlCl₃ est utilisé en une quantité de 0,1 à 3 moles d'AlCl₃ par mole de Cl₃Si-GePh₃, de préférence de 1 à 2 moles d'AlCl₃ par mole de Cl₃Si-GePh₃.

12. Utilisation de trichlorosilyltrichlorogermane fabriqué selon la revendication 10 ou 11, pour la formation de couches de GeSi.
